# EUROPEAN PATENT APPLICATION

(11) **EP 2 164 088 A1**
(43) Date of publication of application: **17.03.2010**
(21) Application number: 08790594.9
(22) Date of filing: 25.06.2008
(51) Int. Cl.: H01H 51/22, B81B 3/00

(54) **A MICRO RELAY**

(30) Priority: 26.06.2007 JP 2007168216; 15.01.2008 JP 2008006112
(71) Applicant: Panasonic Electric Works Co., Ltd, Kadoma-shi Osaka 571-8686 (JP)
(72) Inventor: HAGIHARA, Yosuke, Kadoma-shi Osaka 571-8686 (JP); HASHIMOTO, Takeshi, Kadoma-shi Osaka 571-8686 (JP); UOTOME, Riichi, Kadoma-shi Osaka 571-8686 (JP); ENOMOTO, Hideki, Kadoma-shi Osaka 571-8686 (JP); KAKIMOTO, Katsumi, Kadoma-shi Osaka 571-8686 (JP); YOKOYAMA, Koji, Kadoma-shi Osaka 571-8686 (JP); KISHIMOTO, Shinichi, Kadoma-shi Osaka 571-8686 (JP)
(74) Representative: Appelt, Christian W.
(86) International application number: PCT/JP2008/061527
(87) International publication number: WO 2009/001848

(57) **Abstract**

A micro relay includes a magnetic member and a permanent magnet in addition to a main substrate, a stationary contact, an armature and a coil. The magnetic member includes a core located in a first though hole of the main substrate. The permanent magnet is located at an end of the magnetic member or at a place within the magnetic member. The main substrate has a plurality of laminated layers. The coil is formed of a plurality of planer coils connected in series. The plurality of planer coils are formed on the plurality of laminated layers, respectively and are located around the core.

## Description

### TECHNICAL FIELD

The invention relates generally to micro relays and more particularly to a micro relay incorporated in a substrate.

### BACKGROUND ART

In general, an electromagnetic relay has a coil, a yoke, a permanent magnet, an armature, a stationary contact and a movable contact, and is configured to make or break an electric contact between the contacts by energizing the coil to move the movable contact through the armature. Small-sized micro relays are manufactured by using semiconductor process technology.

For example, a latching relay described in US Patent number 6,894,592 issued on May 17, 2005 includes a substrate, an insulating layer, a contact (a stationary contact), a staging layer, a cantilever (an armature) and a magnet. The insulating layer is placed on one side (an upper surface) of the substrate and houses a conductor. The conductor is arranged in a coil pattern (hereinafter referred to as a "coil"). The stationary contact is placed on one side (an upper surface) of the insulating layer. The staging layer is placed at a position corresponding to the center of the coil, on the one side of the insulating layer. The base of the cantilever is joined on the staging layer so that the tip of the cantilever is positioned above the stationary contact. The cantilever includes a magnetic layer and a conducting layer (a movable contact), and the movable contact is located on the lower part of the cantilever. The magnet is placed on the other side (a lower surface) of the substrate. In an example, the components above are formed on the magnet.

Principle of operation of the latching relay is explained. When the relay is in the "down" position, the movable contact of the cantilever makes electrical contact with the stationary contact, and the relay is held in the "on" ("closed" state). When the movable contact is in the "up", the relay is held in the "off' ("open" state). These two stable states produce a switch function by the cantilever. The magnet holds the cantilever in either "up" or "down" position after switching, making the device function as a latching relay. The coil is energized only during a brief time period of transition between the two states.

However, the coil of the latching relay is a planer coil, and accordingly it is difficult to obtain sufficient ampere turns.

### DISCLOSURE OF THE INVENTION

It is therefore an object of the present invention to provide a thin micro relay capable of increasing ampere turns.

A micro relay of the present invention comprises a main substrate, a stationary contact, an elastically deformable armature, and a coil. The stationary contact is located on one side of the main substrate. The armature is substantially supported by the main substrate so that it can move in and out of contact with the stationary contact by elastic deformation. The coil is used to generate a magnetic field which elastically deforms the armature to make or break an electric contact between a part of the armature and the stationary contact. In a first aspect of the invention, the micro relay further comprises a magnetic member and a permanent magnet. The magnetic member includes a core located in a first though hole of the main substrate. The permanent magnet is located at an end of the magnetic member or at a place within the magnetic member. The main substrate has a plurality of laminated layers. The coil is formed of a plurality of planer coils connected in series. The plurality of planer coils are formed on the plurality of laminated layers, respectively and are located around the core. In this invention, since the coil is formed of the plurality of planer coils connected in series, a thin micro relay capable of increasing ampere turns can be provided.

In a second aspect of the invention, the magnetic member further includes a yoke located in a second though hole of the main substrate. The permanent magnet is formed by depositing a magnetic substance on an end of the yoke so as to face the armature, and generates a magnetic field capable of keeping the electric contact between the part of the armature and the stationary contact even without the magnetic field of the coil. In this invention, since the permanent magnet is formed by depositing the magnetic substance on the end of the yoke, fixing with adhesive is unnecessary and consequently the manufacturing cost can be reduced.

In an embodiment, the main substrate is formed of a plurality of laminated ceramics sheets corresponding to the plurality of laminated layers, respectively. The plurality of planer coils are conductive patterns formed on the plurality of laminated ceramics sheets, respectively. In this embodiment, since the main substrate is formed of the plurality of laminated ceramics sheets, comparatively good high-frequency characteristics can be obtained. The number of turns of the coil can be easily increased, and miniaturization of the micro relay can be realized.

In an embodiment, the micro relay further comprises a cover fixed to the main substrate to cover the stationary contact and the armature. In this embodiment, the stationary contact and the armature can be protected.

In a third aspect of the invention, the micro relay further comprises a cover fixed to the main substrate to cover the stationary contact and the armature. The permanent magnet is a sintered magnet stuck to at least the magnetic member with adhesive including organic material, and is located at a place within the magnetic member so as not to be included inside the cover. In this invention, the sintered magnet has comparatively large magnetic force, and accordingly the micro relay can be miniaturized. In addition, since the permanent magnet is not included inside the cover, it is possible to prevent contact defect caused by an organic film derived from the adhesive.

In an embodiment, a first end of the core is joined to the base of the armature so that the tip of the armature can move in and out of contact with the stationary contact by elastic deformation of the armature. The magnetic member further includes a first yoke and a second yoke. The first yoke is located in a second though hole of the main substrate so that a first end of the first yoke faces the armature. The second yoke is located on the other side of the main substrate. A first end of the second yoke is joined to a second end of the core. A second end of the first yoke and a second end of the second yoke are joined to both magnetic pole faces of the permanent magnet with the adhesive, respectively. In this embodiment, though the permanent magnet is joined to the first yoke, the first yoke can be formed at once.

In an embodiment, the permanent magnet has a larger width than at least the first end of the first yoke in the direction between the core and the first yoke. For example, in comparison with a permanent magnet having the same width as the first end of the first yoke, it is possible to mount a permanent magnet having high magnetic flux.

In an embodiment, the width in the second end side of the first yoke becomes smaller from the second end to the first end of the first yoke. In this structure, leakage of magnetic flux can be reduced.

In an embodiment, a first end of the core is joined to the base of the armature so that the tip of the armature can move in and out of contact with the stationary contact by elastic deformation of the armature. The magnetic member further includes a first yoke and a second yoke. The first yoke is located in a second though hole of the main substrate so that a first end of the first yoke faces the armature. The second yoke is located on the other side of the main substrate. A second end of the core and a first end of the second yoke are joined to both magnetic pole faces of the permanent magnet with the adhesive, respectively. A second end of the second yoke is joined to a second end of the first yoke. In this embodiment, though the permanent magnet is joined to the core, the core can be formed at once.

In an embodiment, the permanent magnet has a larger width than at least the first end of the core in the direction between the core and the first yoke. For example, in comparison with a permanent magnet having the same width as the first end of the core, it is possible to mount a permanent magnet having high magnetic flux.

In an embodiment, a first end of the core is joined to the base of the armature so that the tip of the armature can move in and out of contact with the stationary contact by elastic deformation of the armature. The magnetic member further includes a first yoke and a second yoke. The first yoke is located in a second though hole of the main substrate so that a first end of the first yoke faces the armature. The first yoke is divided into two parts by the permanent magnet between the first end and a second end of the first yoke, and the divided faces of the first yoke are joined to both magnetic pole faces of the permanent magnet, respectively. The adhesive is applied to either of the divided faces. The second yoke is located on the other side of the main substrate. A first end and a second end of the second yoke are joined to a second end of the core and the second end of the first yoke, respectively.

In an embodiment, a first end of the core is joined to the base of the armature so that the tip of the armature can move in and out of contact with the stationary contact by elastic deformation of the armature. The magnetic member further includes a first yoke and a second yoke. The first yoke is located in a second though hole of the main substrate so that a first end of the first yoke faces the armature. The second yoke is located on the other side of the main substrate. A first end and a second end of the second yoke are joined to a second end of the core and a second end of the first yoke, respectively. The core is divided into two parts by the permanent magnet between the first end and the second end of the core, and the divided faces of the core are joined to both magnetic pole faces of the permanent magnet, respectively. The adhesive is applied to either of the divided faces.

In an embodiment, a first end of the core is joined to the base of the armature so that the tip of the armature can move in and out of contact with the stationary contact by elastic deformation of the armature. The magnetic member further includes a first yoke and a second yoke. The first yoke is located in a second though hole of the main substrate so that a first end of the first yoke faces the armature. The second yoke is located on the other side of the main substrate. A first end and a second end of the second yoke are joined to a second end of the core and a second end of the first yoke, respectively. The second yoke is divided into two parts by the permanent magnet between the first end and the second end of the second yoke, and the divided faces of the second yoke are joined to both magnetic pole faces of the permanent magnet with the adhesive, respectively. In this embodiment, the permanent magnet can be easily stuck between the two parts of the second yoke.

In an embodiment, the micro relay further has a gap between the part of the second end side of the second yoke and the permanent magnet. The part of the first end side of the second yoke functions as one terminal which is electrically connected to the core and the armature. For example, in the structure that the first yoke is arranged between the core and the stationary contact, even if a high frequency signal is supplied to the terminal and the stationary contact, it is possible to reduce leakage of the high frequency signal to the stationary contact via the first yoke and the armature.

In an embodiment, the cover comprises a second substrate, a magnetic member and a coil. The second substrate is located above the one side of the main substrate. The magnetic member of the cover includes a core which is arranged opposite the core of the main substrate and supported by the second substrate. The coil of the cover is used to generate a magnetic field which separates the part of the armature from the stationary contact, and is wound around the core supported by the second substrate. In this embodiment, sticking of the part of the armature to the stationary contact can be avoided.

### BRIEF DESCRIPTION OF THE DRAWINGS

Preferred embodiments of the invention will now be described in further details. Other features and advantages of the present invention will become better understood with regard to the following detailed description and accompanying drawings where:
FIG. 1 is a schematic diagram of a micro relay in accordance with a first embodiment of the present invention;
FIGS. 2A and 2B are schematic diagrams of a body of the micro relay;
FIGS. 3A and 3B are schematic diagrams of a cover of the micro relay;
FIG. 4 is a schematic diagram of a micro relay in accordance with a second embodiment of the present invention;
FIGS. 5A and 5B are schematic diagrams of a cover of the micro relay;
FIGS. 6A and 6B are schematic diagrams of a body of the micro relay;
FIG. 7 is a schematic diagram of a micro relay in accordance with a third embodiment of the present invention;
FIG. 8 illustrates a modified example of the micro relay;
FIG. 9 illustrates a modified example of the micro relay;
FIG. 10 is a schematic diagram of a micro relay in accordance with a fourth embodiment of the present invention;
FIG. 11 illustrates a modified example of the micro relay;
FIG. 12 is a schematic diagram of a micro relay in accordance with a fifth embodiment of the present invention;
FIG. 13 is a schematic diagram of a micro relay in accordance with a sixth embodiment of the present invention;
FIG. 14 is a schematic diagram of a micro relay in accordance with a seventh embodiment of the present invention;
FIG. 15 is a schematic diagram of the micro relay; and
FIG. 16 is a schematic diagram of an embodiment.

### BEST MODE FOR CARRYING OUT THE INVENTION

### FIRST EMBODIMENT

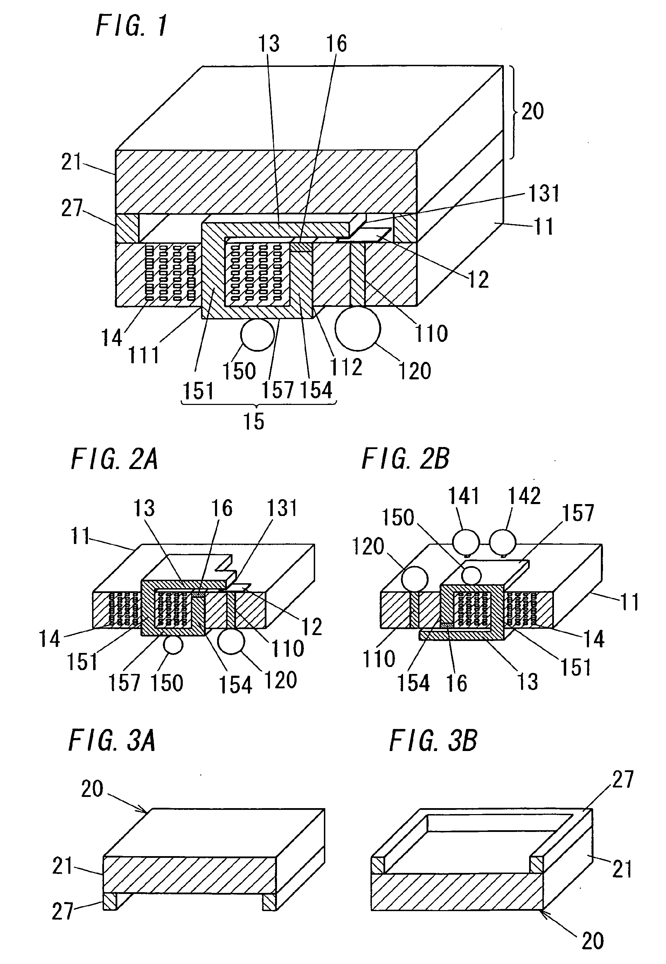

FIG. 1 shows a micro relay in accordance with a first embodiment of the present invention. This micro relay includes a main substrate 11, a stationary contact 12, an armature 13, a coil 14, a magnetic member 15 and a permanent magnet 16, which together constitute a body of the micro relay.

The main substrate 11 has a plurality of laminated layers (not shown). For example, the main substrate 11 is a low temperature co-fired ceramics (LTCC) that is formed of a plurality of laminated ceramics sheets and includes the coil 14. The main substrate 11 further includes a conductive part (e.g., conductive paste coated through hole) 110 formed of a through hole and conductive material, as well as first and second through holes 111 and 112 in which a part of the magnetic member 15, namely a core 151 and a first yoke 154 are located, respectively. The second through hole 112 is located between the first through hole 111 and the conductive part 110. In an example, the conductive part 110 may be included in the LTCC.

The stationary contact 12 is made of conductive material (conductive paste), and is placed on one side (an upper surface) of the main substrate 11. For example, the stationary contact 12 may be made of chromium, gold or the like by spattering, or made of silver, AuNi or the like by plating. The stationary contact 12 is connected with one end of the conductive part 110 of the main substrate 11, and also electrically connected with a bump (i.e., solder ball) 120 that is placed on the other side (a lower surface) of the main substrate 11 and connected with the other end of the conductive part 110.

As shown in FIGS. 1, 2A and 2B, the armature 13 is an elastically deformable cantilever, and is made of magnetic material having conductivity (e.g., Fe-Ni alloy). For example, the armature 13 can be formed by depositing a magnetic layer on a mask placed on the one side of the main substrate 11 to perform etching for removing the mask. This armature 13 is supported by the main substrate 11 through the core 151 of the magnetic member 15 so that a part (e.g., the tip) of the armature 13 can move in and out of contact with the stationary contact 12 by elastic deformation of the armature 13. In FIG. 2A, the armature 13 has a part extended to the stationary contact 12 and a part extended to the first yoke 154. The armature 13 also includes a movable contact 131 that is made of conductive material like the stationary contact 12 and located on the lower part of the tip of the armature 13 so as to face the stationary contact 12. However, not limited to this, the armature 13 is made of magnetic material having conductivity, and accordingly may have no additional movable contact.

The coil 14 is formed of a plurality of (nine in FIG. 1) planer coils connected in series, and used to generate a magnetic field which elastically deforms the armature 13 to make or break an electric contact between the tip of the armature 13 (i.e., movable contact 131) and the stationary contact 12. The plurality of planer coils are conductive patterns formed on the plurality of laminated layers, namely the plurality of laminated ceramics sheets, respectively and are located around the core 151. Each conductive pattern is in the shape of, for example, a rectangular spiral wound around the core 151. In FIG. 1, the inner end of the conductive pattern formed on the first layer (right end of the left half of the conductive pattern) is connected with the inner end of the conductive pattern formed on the second layer laminated on the first layer. The outer end of the conductive pattern formed on the second layer (left end of the left half of the conductive pattern) is also connected with the outer end of the conductive pattern formed on the third layer laminated on the second layer. Similarly, the inner or outer end of conductive pattern formed on each layer is alternately connected with the inner or outer end of conductive pattern formed on its own upper layer. Both ends of the coil 14 are located on the other side (a lower surface) of the main substrate 11 to be connected with bumps 141 and 142 attached to the lower surface. In the first embodiment, since the plurality of planer coils are formed on the plurality of laminated ceramics sheets, the number of turns of the coil 14 can be easily increased and miniaturization of the micro relay can be realized. The main substrate 11 is also formed of the plurality of laminated ceramics sheets, and accordingly comparatively good high-frequency characteristics can be obtained.

In addition to the core 151 and the first yoke 154 above, the magnetic member 15 has a second yoke 157. The core 151 is a flat piece of a magnetic substance having conductivity (e.g., Fe-Ni alloy) and has first and second ends at the upper and lower surfaces of the main substrate 11, respectively. For example, the first end of the core 151 is stuck out from the upper surface of the main substrate 11, while the second end of the core 151 is flush with the lower surface of the main substrate 11. The first end of the core 151 is also joined to the base of the armature 13 so that the tip (movable contact 131) of the armature 13 can move in and out of contact with the stationary contact 12 by elastic deformation of the armature 13.

The first yoke 154 is a flat piece of a magnetic substance having conductivity (e.g., Fe-Ni alloy) and has first and second ends at the upper and lower surfaces of the main substrate 11, respectively. For example, the first end of the first yoke 154 is set back from the upper surface of the main substrate 11 to form a cavity, while the second end of the first yoke 154 is flush with the lower surface of the main substrate 11.

The second yoke 157 is a flat piece of a magnetic substance having conductivity (e.g., Fe-Ni alloy) and located on the other side of the main substrate 11. This second yoke 157 has first and second ends joined to the second ends of the core 151 and the first yoke 154, respectively and also has a bump 150 attached on the surface of the yoke 157. This bump 150 is electrically connected with the movable contact 131 through the second yoke 157, the core 151 and the armature 13. Accordingly, when an electric contact between the tip (movable contact 131) of the armature 13 and the stationary contact 12 is made or broken, an external circuit (not shown) connected with the bumps 120 and 150 is turned on and off, respectively.

The permanent magnet 16 is located at an end of the magnetic member 15. However, not limited to this, the permanent magnet 16 may be located at a place within the magnetic member 15. In the first embodiment, the magnet 16 is located in the cavity formed at the first end of the first yoke 154 to be flush with the upper surface of the main substrate 11, and one magnetic pole (e.g., an N pole) surface of the magnet 16 faces the armature 13 and the other (e.g., an S pole) is in contact with the first end of the yoke 154. The magnet 16 is also configured to generate a magnetic field capable of keeping an electric contact between the tip (movable contact 131) of the armature 13 and the stationary contact 12 even without the magnetic field of the coil 14. According to an aspect of the invention, the permanent magnet 16 is formed by depositing a magnetic substance. For example, the magnetic substance is formed of well known material (e.g., rare-earth element such as Sm or Nd) having large coercive force in and above the cavity by a deposition method (film formation technology) such as an aerosol deposition method, a pulsed laser deposition (PLD) method, a plating method, a screen print method or the like. The magnetic substance is then polished to be flush with the upper surface of the main substrate 11 and magnetized, and thereby the permanent magnet 16 is formed in the cavity. The above-mentioned armature 13, magnetic member 15 and permanent magnet 16 constitute a closed magnetic path.

As shown in FIGS. 1, 3A and 3B, the micro relay further includes a cover 20 that is fixed to the main substrate 11 to cover and protect the stationary contact 12 and the armature 13. The cover 20 is formed of a second substrate 21 and a spacer 27. Each side of the main substrate 11 and second substrate 21 is in the shape of a rectangle, and the second substrate 21 has almost the same plane size as the main substrate 11. The spacer 27 is in the shape of a rectangle frame, and fixed to the edges of one side (a lower surface) of the second substrate 21. Accordingly, the spacer 27 spaces the substrates 11 and 21 when the one side (an upper surface) of the substrate 11 is covered with the cover 20, and an enclosed space is formed between the substrate 11 and the cover 20. For example, if the second substrate 21 is made of the same material as the main substrate 11, heat stress can be reduced when the cover 20 is joined to the main substrate 11 by heating.

The operation of the first embodiment is now explained. First, the coil 14 is energized from an external circuit (not shown) connected with the bumps 141 and 142 so as to generate a magnetic field (magnetic flux) passing through the magnetic member 15 in the same direction as a magnetic field of the permanent magnet 16. Herein, the external circuit is configured to supply an electric current to the coil 14 so that the magnetic force between the armature 13 and the permanent magnet 16 is larger than the spring force of the armature 13 and makes an electric contact between the tip (movable contact 131) of the armature 13 and the stationary contact 12. Accordingly, the tip (movable contact 13) of the armature 13 is in electric contact with the stationary contact 12. Subsequently, even if the external circuit stops energizing, the electric contact between the movable contact 131 and the stationary contact 12 is held.

Subsequently, when the coil 14 is energized from the external circuit so as to generate a magnetic field passing through the magnetic member 15 in the opposite direction to the magnetic field of the permanent magnet 16, the magnetic flux in said closed magnetic path decreases. Consequently, the magnetic force between the armature 13 and the permanent magnet 16 is smaller than the spring return force of the armature 13, and accordingly the electric contact between the movable contact 131 and the stationary contact 12 is broken.

In the first embodiment, since the permanent magnet 16 is formed by depositing a magnetic substance, fixing with adhesive is unnecessary and consequently the manufacturing cost can be reduced.

In an example, the core 151 and the first yoke 154 may be formed by plating the insides of the first and second through holes 111 and 112 with magnetic material having conductivity (e.g., Fe-Ni alloy), respectively. In this method, each of the core 151 and the first yoke 154 becomes a hollow piece.

### SECOND EMBODIMENT

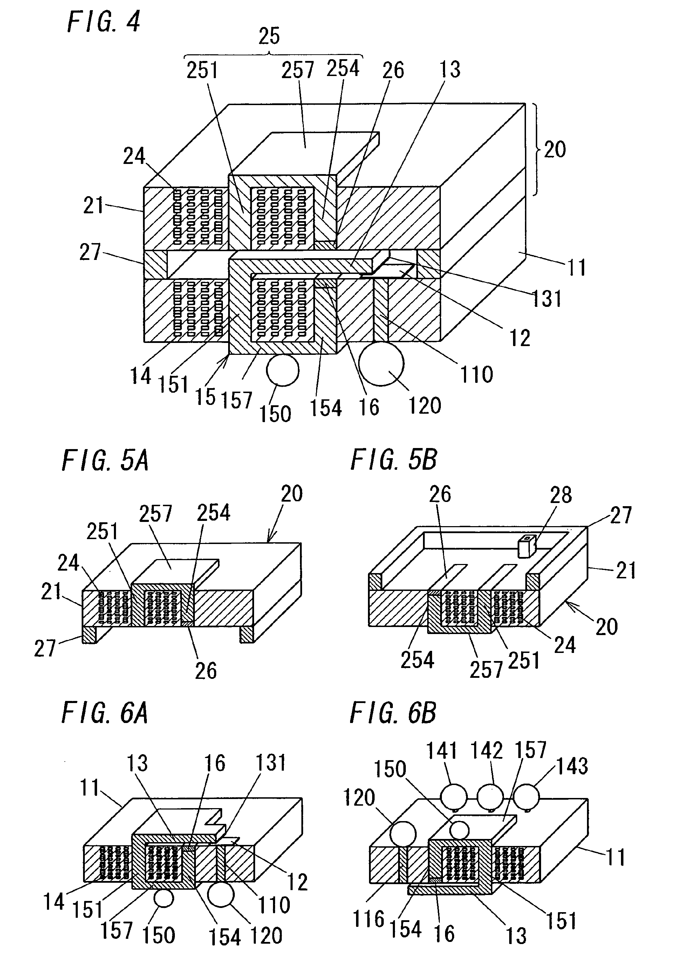

FIG. 4 shows a micro relay in accordance with a second embodiment of the present invention. For the purpose of clarity, like kind elements are assigned the same reference numerals as depicted in the first embodiment. In place of the cover 2 of the first embodiment, the micro relay in the second embodiment includes a cover 2 formed of a second substrate 21, a coil 24, a magnetic member 25, a permanent magnet 26 and a spacer 27.

In the second embodiment, the second substrate 21 is a laminated substrate (e.g., LTCC) like the main substrate 11 of the first embodiment. The coil 24 is formed of a plurality of (nine in FIG. 4) planer coils connected in series like the coil 14 of the first embodiment.

The magnetic member 25 has a core 251, a first yoke 254 and a second yoke 257. Each of the core 251, first yoke 254 and second yoke 257 is a flat piece of a magnetic substance. First and second ends of the core 251 are flush with one side (an upper surface) and the other (a lower surface) of the second substrate 21, respectively. The core 251 is also located above a core 151 of the second embodiment. A first end of the first yoke 254 is flush with the upper surface of the second substrate 21, while a second end of the first yoke 254 is set back from the lower surface of the second substrate 21 to form a cavity. The second yoke 257 is located on the other side (a lower surface) of the second substrate 21 and has first and second ends joined to the first ends of the core 251 and the first yoke 254, respectively.

The permanent magnet 26 is located in the cavity formed at the second end of the first yoke 254 to be flush with the lower surface of the second substrate 21. One magnetic pole (e.g., an N pole) surface of the magnet 26 is in contact with the second end of the yoke 254, while the other magnetic pole (e.g., an S pole) surface faces an armature 13 of the second embodiment. The permanent magnet 26 is also located above a permanent magnet 16 of the second embodiment. In an example, the permanent magnet 26 may be formed like the permanent magnet 16 of the first embodiment, or may be a sintered magnet.

Herein, as shown in FIGS. 5A, 5B, 6A and 6B, a connection part 28 including two conductive wires respectively connected with both ends of the coil 24 is located on the lower surface of the second substrate 21. On the other hands, a bump 143 is attached to the lower surface of a main substrate 11 in the second embodiment to be connected to a conductive part such as a conductive paste coated through hole or the like (not shown). The conductive wires of the connection part 28 are respectively connected with two terminals (not shown) located on the upper surface of the main substrate 11 when the cover 2 is joined on the upper surface of the main substrate 11. One of the two terminals is connected to the conductive part, while the other is connected with one end of a coil 14 in the second embodiment.

The operation of the second embodiment is now explained. When the electric contact between the movable contact 131 and the stationary contact 12 is broken, the coils 14 and 24 are energized from an external circuit (not shown) connected with the bumps 141-143 so that the coil 14 generates a magnetic field like the first embodiment and also the coil 24 generates a magnetic field (magnetic flux) passing through the magnetic member 25 in the same direction as a magnetic field of the permanent magnet 26. Thereby, the permanent magnet 16 repels the yoke 13, while at the same time the magnetic field of the permanent magnet 26 is increased by the magnetic field of the coil 24 to attract the yoke 13 more strongly.

In the second embodiment, sticking of the part (tip) of the armature 13 to the stationary contact 12 can be avoided.

### THIRD EMBODIMENT

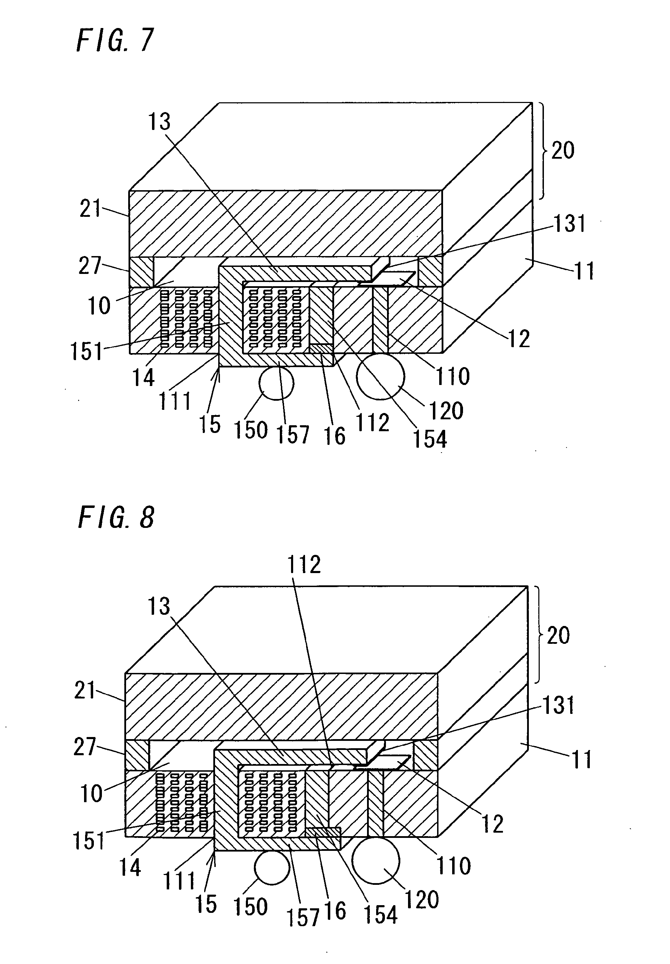

FIG. 7 shows a micro relay in accordance with a third embodiment of the present invention. For the purpose of clarity, like kind elements are assigned the same reference numerals as depicted in the first embodiment.

In the first embodiment, the permanent magnet 16 (magnetic substance) is formed of well known material having large coercive force in and above the cavity by a deposition method such as an aerosol deposition method, a pulsed laser deposition method, a plating method, a screen print method or the like. However, the magnet 16 comes to have a comparatively small magnetic force, and accordingly the magnet 16 needs to be made larger, so that the permanent magnet occupies larger part in the above-mentioned closed magnetic path. Because of this, the number of turns of the coil is increased and the size of the micro relay is increased.

If the permanent magnet 16 is a sintered magnet, the sintered magnet has a comparatively large magnetic force and therefore the magnet 16 can be downsized and an occupation ratio of the magnetic member 15 in the closed magnetic path can be increased. Because of this, the number of turns of the coil is decreased and the size of the micro relay is reduced. However, the sintered magnet requires adhesive in order to mechanically join itself to the main substrate 11 or the magnetic member 15. In the structure of FIG. 1, if the permanent magnet 16 (sintered magnet) is fixed to the first end of the first yoke 154 with adhesive, organic material contained in the adhesive can be vapor to diffuse inside the enclosed space between the substrate 11 and the cover 20. Consequently, an organic film can be formed on each of the stationary contact 12 and the movable contact 131. That is, there is a possibility of contact defect (contact degradation).

In the third embodiment, a permanent magnet 16 is a sintered magnet stuck to at least a magnetic member 15 with adhesive including organic material, but it is possible to prevent contact defect caused by an organic film derived from the adhesive.

As shown in FIG. 7, the micro relay in the third embodiment includes a main substrate 11, a stationary contact 12, an armature 13, a coil 14, a cover 20, and bumps 120, 141, 142 and 150 in the same way as the first embodiment. In addition, the relay further includes a magnetic member 15 (i.e., a core 151 and first and second yokes 154 and 157) and a permanent magnet 16, but the magnet 16 is located at a place within the magnetic member 15 so as not to be included inside the cover 20, namely in the enclosed space 10 between the substrate 11 and the cover 20.

Specifically, a first end of the core 151 is joined to the base of the armature 13 so that the tip (movable contact 131) of the armature 13 can move in and out of contact with the stationary contact 12 by elastic deformation of the armature 13. For example, the first end of the core 151 is stuck out from the upper surface of the main substrate 11, while the second end of the core 151 is flush with the lower surface of the main substrate 11. The first yoke 154 is located in a second though hole 112 of the main substrate 11 so that the first end of the first yoke 154 faces the armature 13. The first end of the first yoke 154 is flush with the upper surface of the main substrate 11, while the second end of the first yoke 154 is set back from the lower surface of the main substrate 11 to form a cavity. The second yoke 157 is located on the lower surface of the main substrate 11. The first end of the second yoke 157 is joined to the second end of the core 151. The second end of the first yoke 154 and the second end of the second yoke 157 are joined to both magnetic pole faces of the permanent magnet 16 with the adhesive, respectively. The permanent magnet 16 is located in the cavity, and the magnetic pole faces of the permanent magnet 16 are arranged like the first embodiment.

In an example, the core 151 and the first yoke 154 may be plating in the first though hole 111 and plating in the second though hole 112, respectively. In this structure, after the core 151 and the first yoke 154 are formed, the permanent magnet 16 is joined to the second end of the first yoke 154 and the main substrate 11 adjacent to the second end with the adhesive. The second yoke 157 is then formed by plating and thereby the second end of the second yoke 157 is joined to the permanent magnet 16.

In the third embodiment, the permanent magnet 16 is located in the cavity so as not to be included in the enclosed space 10, and then fixed with adhesive including organic material, and accordingly it is possible to prevent contact defect caused by an organic film derived from the adhesive. Moreover, since the permanent magnet 16 is a sintered magnet having a comparatively large magnetic force, the magnet 16 can be downsized and an occupation ratio of the magnetic member 15 in the closed magnetic path can be increased. Accordingly, if the magnetic member 15 is formed of the material having high permeability than the permanent magnet 16, iron loss can be reduced. Consequently, the number of turns of the coil can be decreased and the size of the micro relay can be reduced.

In an example, the permanent magnet 16 may have a larger width than at least the first end of the first yoke 154 in the direction between the core 151 and the first yoke 154. For example, as shown in FIG. 8, the magnet 16 has a larger width than the first yoke 154 in the direction. In this structure, since the size of the magnet 16 is increased, it is possible to increase the magnetic flux for holding the electric contact between the stationary contact 12 and the movable contact 131.

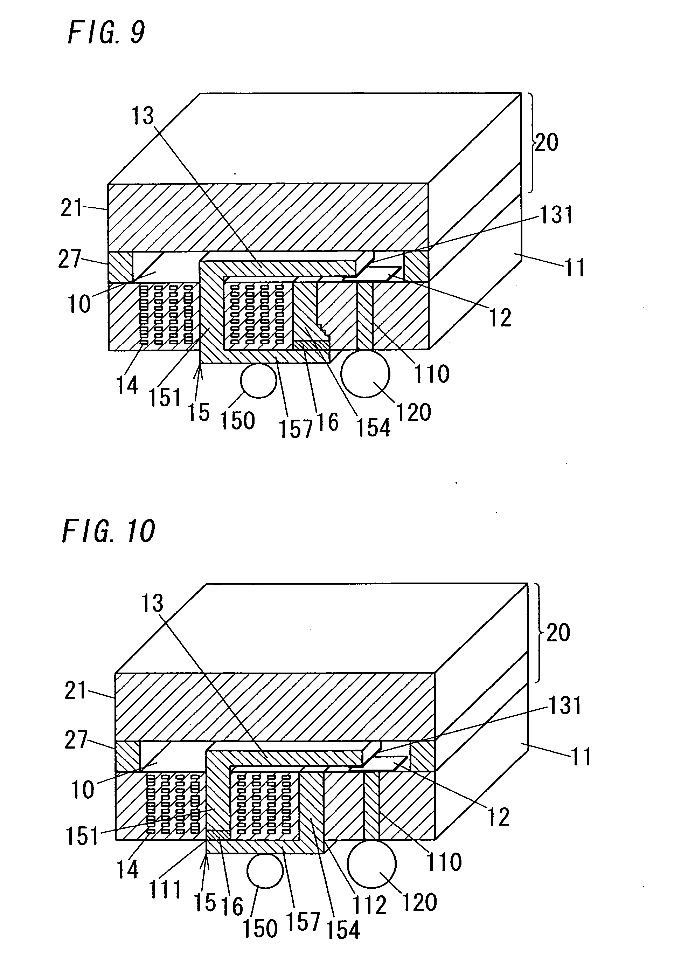

In an example, as shown in FIG. 9, the permanent magnet 16 has a larger width than at least the first end of the first yoke 154 in the direction between the core 151 and the first yoke 154, and the width in the second end side of the first yoke 154 becomes smaller from the second end to the first end of the first yoke 154. Thus, if the end face of the first yoke 154 is matched with the permanent magnet 16, magnetic flux leakage can be avoided in addition to increase of the magnetic flux.

### FOURTH EMBODIMENT

FIG. 10 shows a micro relay in accordance with a fourth embodiment of the present invention. For the purpose of clarity, like kind elements are assigned the same reference numerals as depicted in the first embodiment.

As shown in FIG. 10, the micro relay in the fourth embodiment includes a main substrate 11, a stationary contact 12, an armature 13, a coil 14, a cover 20, and bumps 120, 141, 142 and 150 in the same way as the first embodiment. In addition, the relay further includes a magnetic member 15 (i.e., a core 151 and first and second yokes 154 and 157) and a permanent magnet 16, but the magnet 16 is located at a place within the magnetic member 15 so as not to be included in the enclosed space 10 between the substrate 11 and the cover 20.

Specifically, the first end of the core 151 is joined to the base of the armature 13 so that the tip (movable contact 131) of the armature 13 can move in and out of contact with the stationary contact 12 by elastic deformation of the armature 13. For example, the first end of the core 151 is stuck out from the upper surface of the main substrate 11, while the second end of the core 151 is set back from the lower surface of the main substrate 11 to form a cavity. The first yoke 154 is located in a second though hole 112 of the main substrate 11 so that the first end of the first yoke 154 faces the armature 13. For example, the first and second ends of the first yoke 154 are flush with the upper and lower surfaces of the main substrate 11, respectively. The second yoke 157 is located on the lower surface of the main substrate 11. The second end of the core 151 and the first end of the second yoke 157 are joined to one magnetic pole (e.g., an S pole) surface and the other magnetic pole (e.g., an N pole) surface of the permanent magnet 16 with adhesive including organic material, respectively. The second end of the second yoke 157 is joined to the second end of the first yoke 154.

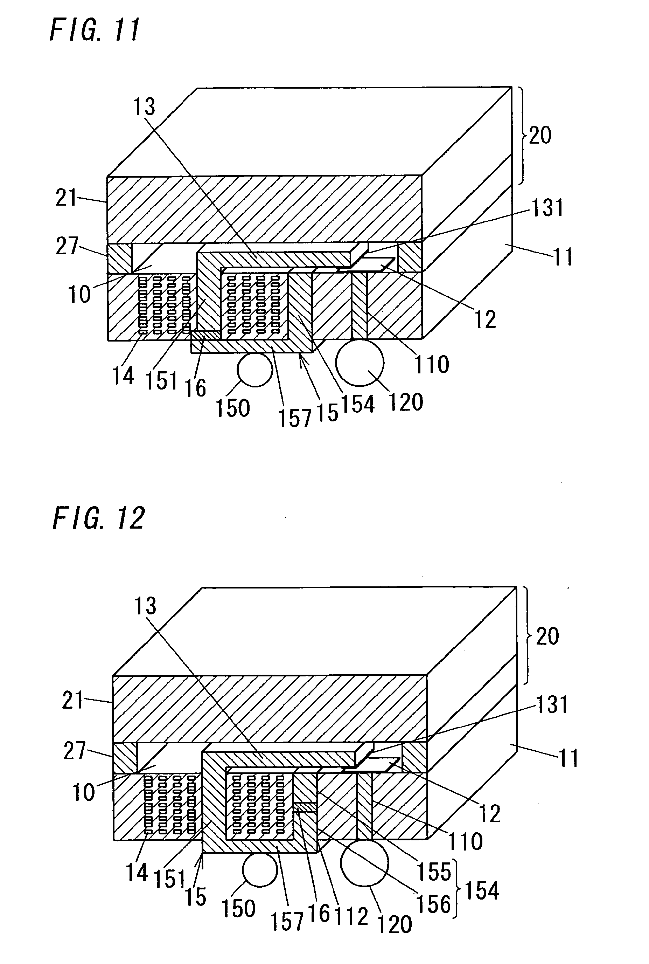

In an example, the permanent magnet 16 may have a larger width than at least the first end of the core 151 in the direction between the core 151 and the first yoke 154. For example, as shown in FIG. 11, the magnet 16 has a larger width than the core 151 in the direction. In this structure, since the size of the magnet 16 is increased, it is possible to increase the magnetic flux for holding the electric contact between the stationary contact 12 and the movable contact 131.

### FIFTH EMBODIMENT

FIG. 12 shows a micro relay in accordance with a fifth embodiment of the present invention. For the purpose of clarity, like kind elements are assigned the same reference numerals as depicted in the first embodiment.

As shown in FIG. 12, the micro relay in the fifth embodiment includes a main substrate 11, a stationary contact 12, an armature 13, a coil 14, a cover 20, and bumps 120, 141, 142 and 150 in the same way as the first embodiment. In addition, the relay further includes a magnetic member 15 (i.e., a core 151 and first and second yokes 154 and 157) and a permanent magnet 16, but the magnet 16 is located at a place within the magnetic member 15 so as not to be included in the enclosed space 10 between the substrate 11 and the cover 20.

Specifically, the first end of the core 151 is joined to the base of the armature 13 so that the tip (movable contact 131) of the armature 13 can move in and out of contact with the stationary contact 12 by elastic deformation of the armature 13. For example, the first end of the core 151 is stuck out from the upper surface of the main substrate 11, while the second end of the core 151 is flush with the lower surface of the main substrate 11. The first yoke 154 is located in a second though hole 112 of the main substrate 11 so that the first end of the first yoke 154 faces the armature 13. For example, the first and second ends of the first yoke 154 are flush with the upper and lower surfaces of the main substrate 11, respectively. The first yoke 154 is also divided into two parts 155 and 156 by the permanent magnet 16 between the first and second ends of the first yoke 154, the divided faces of the parts 155 and 156 are joined to one magnetic pole (e.g., an N pole) surface and the other magnetic pole (e.g., an S pole) surface of the permanent magnet 16, respectively. Adhesive including organic material is applied to either of the divided faces. The second yoke 157 is located on the lower surface of the main substrate 11. The first end and the second end of the second yoke 157 are joined to the second end of the core 151 and the second end of the first yoke 154, respectively.

### SIXTH EMBODIMENT

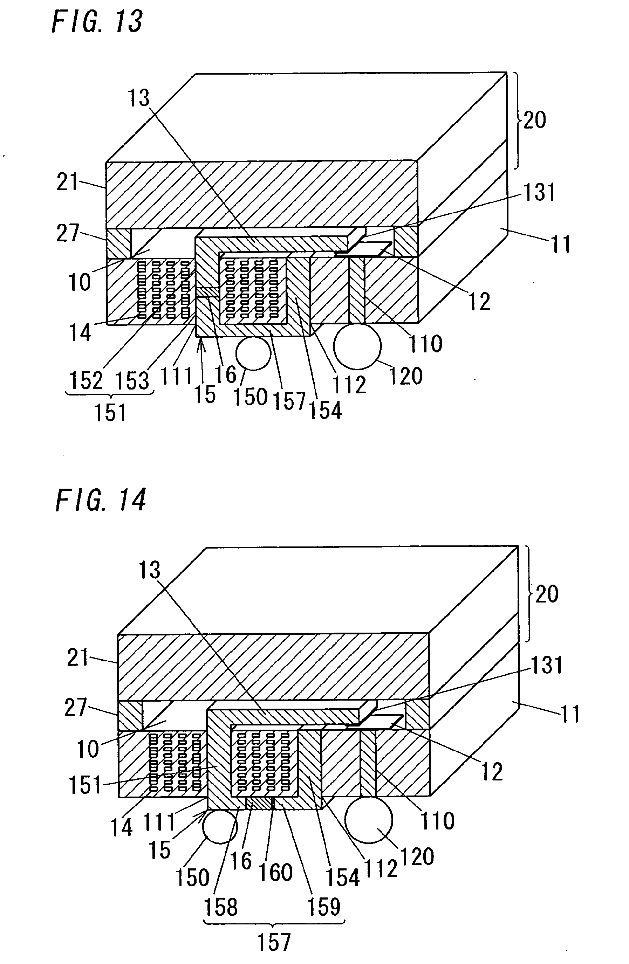

FIG. 13 shows a micro relay in accordance with a sixth embodiment of the present invention. For the purpose of clarity, like kind elements are assigned the same reference numerals as depicted in the first embodiment.

As shown in FIG. 13, the micro relay in the sixth embodiment includes a main substrate 11, a stationary contact 12, an armature 13, a coil 14, a cover 20, and bumps 120, 141, 142 and 150 in the same way as the first embodiment. In addition, the relay further includes a magnetic member 15 (i.e., a core 151 and first and second yokes 154 and 157) and a permanent magnet 16, but the magnet 16 is located at a place within the magnetic member 15 so as not to be included in the enclosed space 10 between the substrate 11 and the cover 20.

Specifically, the first end of the core 151 is joined to the base of the armature 13 so that the tip (movable contact 131) of the armature 13 can move in and out of contact with the stationary contact 12 by elastic deformation of the armature 13. For example, the first end of the core 151 is stuck out from the upper surface of the main substrate 11, while the second end of the core 151 is flush with the lower surface of the main substrate 11. The first yoke 154 is located in a second though hole 112 of the main substrate 11 so that the first end of the first yoke 154 faces the armature 13. For example, the first and second ends of the first yoke 154 are flush with the upper and lower surfaces of the main substrate 11, respectively. The second yoke 157 is located on the lower surface of the main substrate 11. The first end and the second end of the second yoke 157 are joined to the second end of the core 151 and the second end of the first yoke 154, respectively. Herein, the core 151 is divided into two parts 152 and 153 by the permanent magnet 16 between the first and the second ends of the core 151, and the divided faces of the parts 152 and 153 are joined to one magnetic pole (e.g., an S pole) surface and the other magnetic pole (e.g., an N pole) surface of the magnet 16, respectively. Adhesive including organic material is applied to either of the divided faces.

### SEVENTH EMBODIMENT

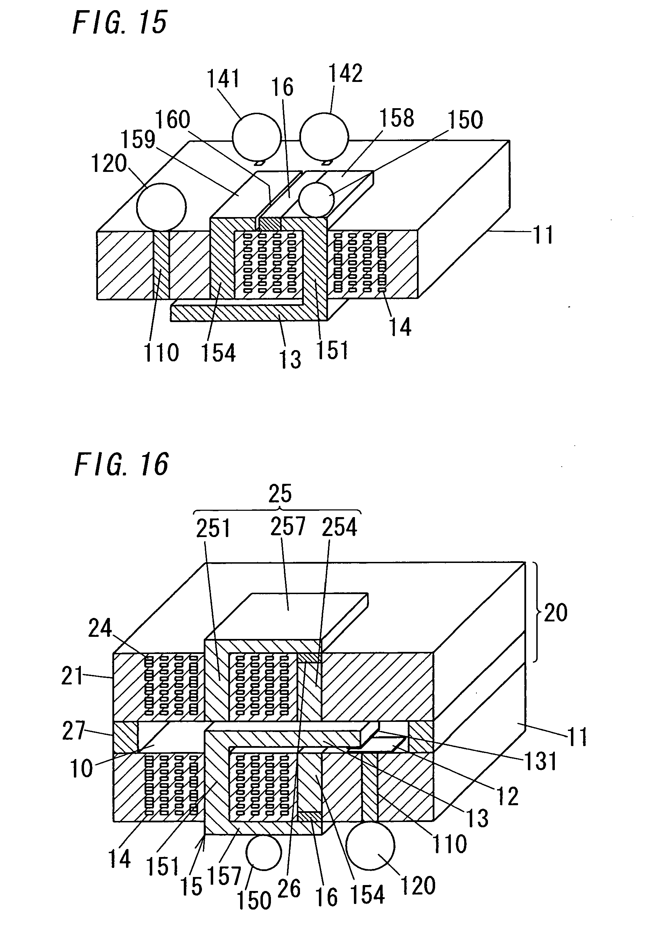

FIG. 14 and 15 show a micro relay in accordance with a seventh embodiment of the present invention. For the purpose of clarity, like kind elements are assigned the same reference numerals as depicted in the first embodiment.

The micro relay in the seventh embodiment includes a main substrate 11, a stationary contact 12, an armature 13, a coil 14, a cover 20, and bumps 120, 141, 142 and 150 in the same way as the first embodiment. In addition, the relay further includes a magnetic member 15 (i.e., a core 151 and first and second yokes 154 and 157) and a permanent magnet 16, but the magnet 16 is located at a place within the magnetic member 15 so as not to be included in the enclosed space 10 between the substrate 11 and the cover 20.

Specifically, the first end of the core 151 is joined to the base of the armature 13 so that the tip (movable contact 131) of the armature 13 can move in and out of contact with the stationary contact 12 by elastic deformation of the armature 13. For example, the first end of the core 151 is stuck out from the upper surface of the main substrate 11, while the second end of the core 151 is flush with the lower surface of the main substrate 11. The first yoke 154 is located in a second though hole 112 of the main substrate 11 so that the first end of the first yoke 13 faces the armature 13. For example, the first and second ends of the first yoke 154 are flush with the upper and lower surfaces of the main substrate 11, respectively. The second yoke 157 is located on the lower surface of the main substrate 11. The first end and second end of the second yoke 157 are joined to the second end of the core 151 and the second end of the first yoke 154, respectively. Herein, the second yoke 157 is divided into two parts 158 and 159 by the permanent magnet 16 between the first and second ends of the second yoke 157, and the divided faces of the parts 158 and 159 are joined to one magnetic pole (e.g., an S pole) surface and the other magnetic pole (e.g., an N pole) surface of the magnet 16 with adhesive including organic material, respectively. In this structure, the permanent magnet 16 can be easily stuck between the two parts 158 and 159 of the second yoke 157.

The micro relay further has a gap 160 between the part 159 of the second end side of the second yoke 157 and the permanent magnet 16. The part 158 of the first end side of the second yoke 157 is also connected with the bump 150, and functions as one terminal which is electrically connected to the core 151 and the armature 13. In the structure that the first yoke 154 is arranged between the core 151 and the stationary contact 12, two paths exist between the terminal and the stationary contact 12. The first path is formed of the part 158, core 151 and the armature 13, while the second path is formed of the part 158, the permanent magnet 16, the part 159, the first yoke 154 and the armature 13. Even if a high frequency RF signal is supplied to the terminal and the stationary contact 12, the gap 160 exists between the part 159 and the magnet 16 and accordingly it is possible to reduce leakage of the signal to the stationary contact 12 via the first yoke 154 and the armature 13 (i.e., second path).

In an embodiment, each micro relay of the third to seventh embodiments may have a cover 20 with coil in almost the same way as the cover of the second embodiment, in place of a cover 20 without coil. For example, the micro relay in the third embodiment may have a cover 20 as shown in FIG. 16. This cover 20 includes a second substrate 21, a coil 24, a spacer 27 and a connection part 28 like the cover of the second embodiment, while the body of FIG. 16 further includes a bump 143 and a conductive part like the body of the second embodiment.

In FIG. 16, the cover 20 further includes a magnetic member 25 and a permanent magnet 26. The magnetic member 25 has a core 251, a first yoke 254 and a second yoke 257, and the core 251 and second yoke 257 are formed like those of the second embodiment. The first end of the first yoke 254 is set back from the upper surface of the second substrate 21 to form a cavity, while the second end of the first yoke 254 is flush with the lower surface of the second substrate 21. The permanent magnet 26 is located in the cavity formed at the first end of the first yoke 254 to be flush with the upper surface of the second substrate 21. One magnetic pole (e.g., an N pole) surface of the magnet 26 is in contact with the second end of the second yoke 257, while the other magnetic pole (e.g., an S pole) surface faces the first end of the first yoke 254. Thus, the permanent magnet 26 is located at a place within the magnetic member 25 so as not to be included in the enclosed space 10 between the substrate 11 and the cover 20. Accordingly, the advantage like the second embodiment is obtained. In addition, even if adhesive including organic material is used to fix the permanent magnet 26, it is possible to prevent contact defect caused by an organic film derived from the adhesive. However, not limited to the example of FIG. 16, the permanent magnet 26 may be located like each permanent magnet 16 of the third to seventh embodiments. The cover 20 may also have no permanent magnet.

In an embodiment, each body of the micro relays of the first to seventh embodiments may further have: a shield pattern that is located on one side (an upper surface) of the main substrate 11 and surrounds the stationary contact 12 and the magnetic member 15; and a bump that is located on the other side (a lower surface) of the substrate 11 and electrically connected with the shield pattern through a conductive part (e.g., conductive paste coated through hole).

Although the present invention has been described with reference to certain preferred embodiments, numerous modifications and variations can be made by those skilled in the art without departing from the true spirit and scope of this invention.

## Claims

1. A micro relay, comprising:
a main substrate;
a stationary contact located on one side of the main substrate;
an elastically deformable armature which is substantially supported by the main substrate so that it can move in and out of contact with the stationary contact by elastic deformation; and
a coil for generating a magnetic field which elastically deforms the armature to make or break an electric contact between a part of the armature and the stationary contact;
wherein the micro relay further comprises:
a magnetic member including a core located in a first though hole of the main substrate; and
a permanent magnet located at an end of the magnetic member or at a place within the magnetic member;
wherein the main substrate has a plurality of laminated layers,
wherein the coil is formed of a plurality of planer coils connected in series, and
wherein the plurality of planer coils is formed on the plurality of laminated layers, respectively and is located around the core.

2. The micro relay of claim 1,
wherein the magnetic member further includes a yoke located in a second though hole of the main substrate, and
wherein the permanent magnet is formed by depositing a magnetic substance on an end of the yoke so as to face the armature, and generates a magnetic field capable of keeping the electric contact between the part of the armature and the stationary contact even without the magnetic field of the coil.

3. The micro relay of claim 2,
wherein the main substrate is formed of a plurality of laminated ceramics sheets corresponding to the plurality of laminated layers, respectively, and
wherein the plurality of planer coils are conductive patterns formed on the plurality of laminated ceramics sheets, respectively.

4. The micro relay of claim 2 or 3, further comprising a cover that is fixed to the main substrate to cover the stationary contact and the armature.

5. The micro relay of claim 1, further comprising a cover that is fixed to the main substrate to cover the stationary contact and the armature,
wherein the permanent magnet is a sintered magnet stuck to at least the magnetic member with adhesive including organic material, and is located at a place within the magnetic member so as not to be included inside the cover.

6. The micro relay of claim 5,
wherein a first end of the core is joined to the base of the armature so that the tip of the armature can move in and out of contact with the stationary contact by elastic deformation of the armature,
wherein the magnetic member further includes a first yoke and a second yoke,
wherein the first yoke is located in a second though hole of the main substrate so that a first end of the first yoke faces the armature,
wherein the second yoke is located on the other side of the main substrate,
wherein a first end of the second yoke is joined to a second end of the core, and
wherein a second end of the first yoke and a second end of the second yoke are joined to both magnetic pole faces of the permanent magnet with the adhesive, respectively.

7. The micro relay of claim 6, wherein the permanent magnet has a larger width than at least the first end of the first yoke in the direction between the core and the first yoke.

8. The micro relay of claim 7, wherein the width in the second end side of the first yoke becomes smaller from the second end to the first end of the first yoke.

9. The micro relay of claim 5,
wherein a first end of the core is joined to the base of the armature so that the tip of the armature can move in and out of contact with the stationary contact by elastic deformation of the armature,
wherein the magnetic member further includes a first yoke and a second yoke,
wherein the first yoke is located in a second though hole of the main substrate so that a first end of the first yoke faces the armature,
wherein the second yoke is located on the other side of the main substrate,
wherein a second end of the core and a first end of the second yoke are joined to both magnetic pole faces of the permanent magnet with the adhesive, respectively, and
wherein a second end of the second yoke is joined to a second end of the first yoke.

10. The micro relay of claim 9, wherein the permanent magnet has a larger width than at least the first end of the core in the direction between the core and the first yoke.

11. The micro relay of claim 5,
wherein a first end of the core is joined to the base of the armature so that the tip of the armature can move in and out of contact with the stationary contact by elastic deformation of the armature,
wherein the magnetic member further includes a first yoke and a second yoke,
wherein the first yoke is located in a second though hole of the main substrate so that a first end of the first yoke faces the armature,
wherein the first yoke is divided into two parts by the permanent magnet between the first end and a second end of the first yoke, the divided faces of the first yoke being joined to both magnetic pole faces of the permanent magnet, respectively, the adhesive being applied to either of the divided faces,
wherein the second yoke is located on the other side of the main substrate, and
wherein a first end and a second end of the second yoke are joined to a second end of the core and the second end of the first yoke, respectively.

12. The micro relay of claim 5,
wherein a first end of the core is joined to the base of the armature so that the tip of the armature can move in and out of contact with the stationary contact by elastic deformation of the armature,
wherein the magnetic member further includes a first yoke and a second yoke,
wherein the first yoke is located in a second though hole of the main substrate so that a first end of the first yoke faces the armature,
wherein the second yoke is located on the other side of the main substrate,
wherein a first end and a second end of the second yoke are joined to a second end of the core and a second end of the first yoke, respectively, and
wherein the core is divided into two parts by the permanent magnet between the first end and the second end of the core, the divided faces of the core being joined to both magnetic pole faces of the permanent magnet, respectively, the adhesive being applied to either of the divided faces.

13. The micro relay of claim 5,
wherein a first end of the core is joined to the base of the armature so that the tip of the armature can move in and out of contact with the stationary contact by elastic deformation of the armature,
wherein the magnetic member further includes a first yoke and a second yoke,
wherein the first yoke is located in a second though hole of the main substrate so that a first end of the first yoke faces the armature,
wherein the second yoke is located on the other side of the main substrate,
wherein a first end and a second end of the second yoke are joined to a second end of the core and a second end of the first yoke, respectively, and
wherein the second yoke is divided into two parts by the permanent magnet between the first end and the second end of the second yoke, the divided faces of the second yoke being joined to both magnetic pole faces of the permanent magnet with the adhesive, respectively.

14. The micro relay of claim 13, further having a gap between the part of the second end side of the second yoke and the permanent magnet,
wherein the part of the first end side of the second yoke functions as one terminal which is electrically connected to the core and the armature.

15. The micro relay of claim 4 or 5, wherein the cover comprises:
a second substrate located above the one side of the main substrate;
a magnetic member including a core which is arranged opposite the core of the main substrate and supported by the second substrate; and
a coil for generating a magnetic field which separates the part of the armature from the stationary contact, the coil being wound around the core supported by the second substrate.
